# EUROPEAN PATENT SPECIFICATION

(11) **EP 2 670 022 B1**
(45) Date of publication and mention of the grant of the patent: **26.12.2018**
(21) Application number: 13169664.3
(22) Date of filing: 29.05.2013
(51) Int. Cl.: H02J 13/00, G06T 11/40, H02J 7/34, H02J 7/32, H02J 3/32, H02J 3/38

(54) **Power monitoring system and method of displaying power system information**
Leistungsüberwachungssystem und Verfahren zum Anzeigen von Leistungssysteminformationen
Système de surveillance de puissance et procédé permettant d'afficher des informations de système électrique

(30) Priority: 01.06.2012 KR 20120059146
(43) Date of publication of application: 04.12.2013
(73) Proprietor: LSIS Co., Ltd., Dongan-Gu, Anyang Gyeonggi-Do (KR)
(72) Inventor: Kim, Byung Seop, 431-080 Anyang-si Gyeonggi-do (KR); Kim, Tae Kwon, 431-080 Anyang-si Gyeonggi-do (KR)
(74) Representative: K&L Gates LLP

(56) References cited:
- EP-A2- 2 437 372
- WO-A1-2009/046533
- WO-A1-2012/005274
- US-A1- 2010 324 962

## Description

### BACKGROUND

The embodiment relates to a power monitoring system and a method of displaying power system information. More particularly, the embodiment relates to a power monitoring system capable of improving user's convenience and a method of displaying power system information. In more detail, the embodiment relates to a power monitoring system capable of displaying new renewable energy and battery power information and a method of displaying power system information.

In general, a power monitoring system performs protection and control functions of monitoring operation states of various kinds of electric power apparatuses, measuring/monitoring an electric amount and breaking a path when an electric power accident occurs by integrally monitoring the power equipment in a reception and distribution system of a factory including a power system such as transmission and distribution system or various kinds of industrial equipment by using a computer.

Such a power monitoring system flexibly cooperates with another system by duplicating all equipment and a network and operating an interface module in order to secure reliability and stability of the system operation, and in addition, performs an additional function such as data communication and remote monitoring control.

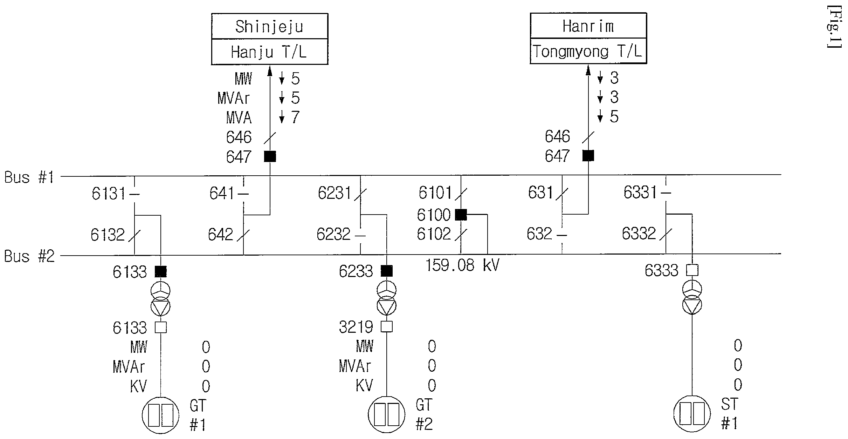

FIG. 1 is a view showing a monitoring image provided by a conventional power monitoring system.

As shown in FIG. 1, the conventional power monitoring system may display active and reactive powers provided from conventional generator equipment (such as a thermal generation plant, a nuclear power generation plant, hydroelectric power generation plant or gas turbine power generation plant), transformer equipment, breaker equipment and a power supply path on a monitoring screen by using symbols.

However, a monitoring screen interface of the conventional power monitoring system displays information about a power system only with symbols and numerals so that a situation of the power monitoring system cannot be intuitively provided to a user. In addition, the monitoring screen interface of the conventional power monitoring system cannot reflect a situation of a power system including a new renewal energy unit and a battery unit which are currently varied due to the introduction of new renewal energy.
WO 2012/005274 A1 titled "Power Control Device discloses a device which solves the problems that arise when a power conditioner similar to that which is connected to a solar panel is connected to an electricity storage device.

### SUMMARY

Aspects of the invention are disclosed in independent claims 1 and 6. The dependent claims show advantageous improvements of the invention as claimed in the independent claims.

### BRIEF DESCRIPTION OF THE DRAWINGS

FIG. 1 is a view showing a monitoring image provided by a conventional power monitoring system;
FIG. 2 is a schematic view showing an entire power system including a power monitoring system according to the embodiment;
FIG. 3 is a flowchart illustrating a method of displaying power system information according to an embodiment;
FIG. 4 is a view illustrating in detail a monitoring image of a power monitoring system according to an embodiment; and
FIG. 5 is a view showing a shape of the battery unit in the monitoring image of the power monitoring system shown in FIG. 4.

### DETAILED DESCRIPTION OF THE EMBODIMENTS

The principle of the embodiments will be described below. Therefore, although not specifically described and depicted in the specification, a person having the ordinary skill in the art may realize the principle of the embodiments and may invent various apparatuses within the concept and scope of the embodiments. Further, in principle, conditional terms and embodiments mentioned in the specification shall be obviously intended to understand the concept of the embodiments and may not limit the scope of the embodiments.

Further, it shall be understood that all detailed descriptions, which teach a specific embodiment as well as a principle, an aspect and embodiments, are intended to include structural and functional equivalents. Further, it should be understood that the equivalents may include equivalents to be developed in the future as well as known equivalents and may include all devices invented for performing the same functions regardless of the structure thereof.

Accordingly, for example, it should be understood that a block diagram of the specification illustrates a conceptual point of view of an illustrative circuit that realizes principles of the embodiment. In the same manner, it should be understood that all flowcharts, state transition diagrams, and pseudo codes may be actually represented in a computer readable medium and may represent various processes to be executed by a computer or a processor regardless of whether the computer or the processor is clearly shown.

Functions of various devices shown in drawings including a processor or a function block expressed as a concept similar to the processor may be provided by using hardware capable of executing suitable software as well as dedicated hardware. When the functions are provided by the processor, the functions may be provided by a single dedicated processor, a single shared processor, or a plurality of individual processors and a part of the functions may be shared.

It should be understood that use of a processor, a control or the term presented as a similar concept to the processor and the control shall not be interpreted as exclusively referring to hardware capable of executing software but shall be understood that it implicitly includes a digital signal processor (DSP), ROM, RAM, and non-volatile memory storing hardware and software. Other hardware generally known in the art may be included.

In the accompanying claims, components expressed as a unit to perform a function disclosed in the detailed description are intended to include a combination of circuit devices performing the above function and all methods of performing the above function, such as various types of software including a firmware/micro-code. The components are incorporated with suitable for executing the software. Since the disclosure defined by the claims is incorporated with functions of units that are variously provided and the form required by the claims, those skilled in the art should comprehend that any unit to provide the function is equivalent of the disclosure.

The above objects, features, and advantages can be more clearly comprehended through the following description in relation to accompanying drawings. Accordingly, those skilled in the art can easily realize the present inventive concept. In the following description, if detailed description about well-known functions or configurations may make the subject matter of the disclosure unclear, the detailed description will be omitted.

Hereinafter, one exemplary embodiment will be described in detail with reference to accompanying drawings.

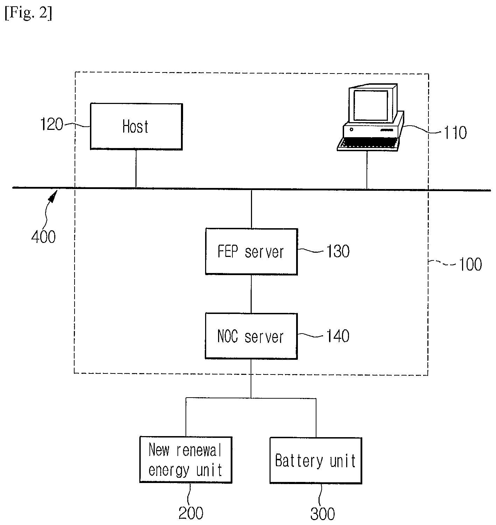

FIG. 2 is a schematic view showing an entire power system including a power monitoring system according to the embodiment.

As shown FIG. 2, the entire power system including a power monitoring system according to the embodiment may include a new renewal energy unit 200 for receiving electric power from a new renewal energy source to supply the electric power to a power system 400, a battery unit 300 which is charged with the electric power provided from the new renewal energy unit 200 and supplying an electric power to a load, and a power management unit 100 which is connected to the power system 400 to manage the new renewal energy unit 200 and the battery unit 300 and provide a monitoring image to a user.

The power management unit 100 may include an NOC (Network Operation Center) server 140 for collecting and storing power information about the new renewal energy unit 200 which is a field equipment and the battery unit 300, and an FEP (Front End Processor) server 130 which engages in communication between the NOC server 140 and a host server 120 to transfer the power information provided from the NOC server 140 to the host server 120. In addition, the power management unit 100 may further include a client 110 which is connected to the host server 120 to receive and display power monitoring system information or the monitoring image data.

The new renewal energy unit 200 receives an electric power from the new renewal energy source and provides the electric power to the power system 400. The new renewal energy unit 200 transmits power data including information about the electric power currently supplied to the power management unit 100.

The new renewal energy can be obtained by converting existing fossil fuel or renewable energy including sunlight, water, geotherm and biological organism, and refers to future energy resources for a continuous energy supply system. The importance of new renewal energy is increased due to the unstable oil price and regulations of UNFCCC (United Nations Framework Conversion on Climate Change). In Korea, 11 fields including renewal energies of 8 fields (solar heat, photovoltaic generation, biomass, wind power generation, small hydropower, geotherm, ocean energy and waste energy) and new energies of 3 fields (fuel cell, coal liquefaction and hydrogen energy) are designated as the new renewal energy.

Meanwhile, the battery unit 300 is connected to the power system 400, such that the battery unit 300 is charged with the electric power provided from the new renewal energy unit 200 or provides the electric power to the load. Further, the battery unit 300 transmits at least one of battery unit connection state information, power information and charged state information to the power management unit 100.

The battery unit 300 is linked to the new renewal energy unit 200 and provides the electric power to the power system 400. Since the properties of each energy source of new renewal energies are different from each other and its advantages and disadvantages are different from each other, several conditions for generating electric power are variable. However, since the amount of generation power output to the new renewal energy source is constant, the new renewal energy unit 200 can supply a stable electric power in connection with the battery unit 300. Therefore, for example, the battery unit 300 may include a BESS (Battery Energy Storage System) which is connected to the new renewal energy unit 200.

The power management unit 100 may manage the new renewal energy unit 200 and the battery unit 300, generate a GUI based monitoring image based on new renewal energy power information, the battery power information or the battery connection state information and provide the GUI based monitoring image to a user. This may be implemented in the host server 120 or the client 110 of the power management unit 100.

The power management unit 100 may include the NOC (Network Operation Center) server 140 for collecting power information of the new renewal energy unit 200 which is a field equipment and the battery unit 300. The NOC server 140 may collect and store information about an amount of reactive or active power provided to the power system 400, and may transmit the information to the host server 140 through the FEP server 130.

The power management unit 100 may link the communication between the NOC server 140 and the host server 120 and may include the FEP server 130 for transferring the power information provided from the NOC server 140 to the host server 120. The FEP server 130 may further a communication system for linking the NOC server 140 and the host server 120 to each other. The communication system of the FEP server 130 may provide an interface for a connection with wired/wireless networks. The FEP server 130 may have, for example, an Ethernet interface for a connection with a wired network, and may use wireless LAN (WLAN) (Wi-Fi), wireless broadband (Wibro), world interoperability for microwave access (Wimax), and high speed downlink packet access (HSDPA) communication standards for a connection with a wireless network.

Meanwhile, the power management unit 100 may further include the client 110 which accesses to the host server 120 to receive the power monitoring system information or the monitoring image data and display the monitoring image data. The client 110 may further include a display. For example, the display may be realized by using a PDP, an LCD, an OLED, a flexible display or a 3D display. In addition, the display may be implemented by using a touch screen to serve as an input device in addition to the output device.

The host server 120 receives information about the power system connection state from the power system 400 and generates the GUI based monitoring image according to the information about the power system connection state and the information received from the new renewal energy unit 200 and the battery unit 300. The generated monitoring image may be reproduced at a display (not shown) connected to the host server 120 or the client apparatus 110. Further, the host server 120 may provide the real-time power data or the monitoring image to the client apparatus 110 according to a data request of the client apparatus 110.

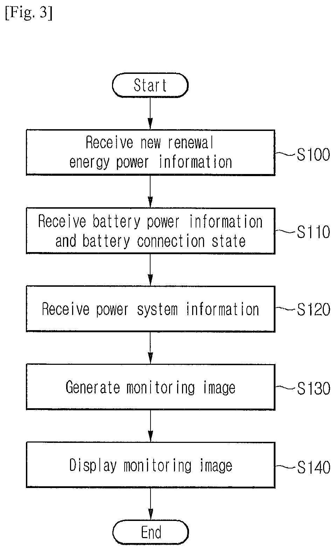

FIG. 3 is a flowchart illustrating a method of displaying power system information according to an embodiment.

Hereinafter, a method of display power system information will be described with reference to FIG. 3.

First, in step S100, the power management unit 100 receives the new renewal energy power information from the new renewal energy unit 200. The new renewal energy power information may include active or reactive electric power values provided from the new renewal energy unit 200 to the power system 400.

In step S110, the power management unit 100 receives the battery power information and the battery connection state information from the battery unit 300. The battery power information may include at least one of battery charging information about a battery charging state converted into a percentage value, and information about connection states between a plurality of batteries which constitutes the battery unit and whether each of the batteries is shut off.

In step S120, the power management unit 100 analyzes the power system 400 to generate the power system information including the information about the connection state of the power system 400 or receive the power system information from an outside.

In step S130, the power management unit 100 generates the GUI based monitoring image based on the new renewal energy information, the battery power information, the battery connection state information and the power system information. Such a detailed configuration of the monitoring image will be described below.

In step S140, the power management unit 100 provides the generated monitoring image to the display (not shown) connected to the host server 120 or a display of the client apparatus 110 such that the generated monitoring image is displayed thereon.

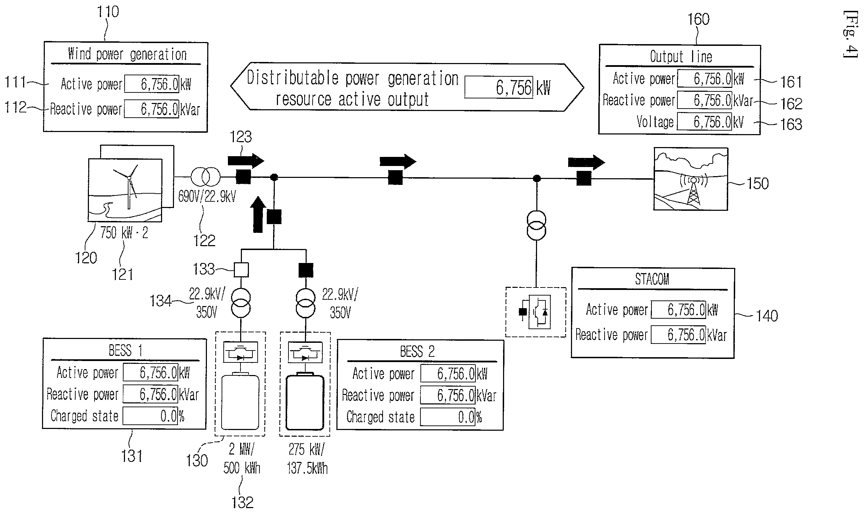

FIG. 4 is a view illustrating in detail a monitoring image of a power monitoring system according to an embodiment.

Hereinafter, a monitoring image of a power monitoring system will be described with reference to FIG. 4.

New renewal energy electric power generation equipment information 120 is disposed at one side of the monitoring image, such that new renewal energy equipment information 121 may be provided together with an image or picture of a new renewal energy electric power equipment. As shown in FIG. 4, two new renewal energy generators, each of which generates 750kW electric power and is working, may be displayed through the new renewal energy equipment information 121. Further, voltage transformation information 122 of a transformer connected to the new renewal energy source may be displayed.

Meanwhile, new renewal energy electric power information 110 may be displayed at a left upper end of the monitoring image. As shown at the left upper end of FIG. 4, the new renewal energy electric power information 110 may include an active and reactive electric power value.

A power supplying direction is denoted as an arrow 123 in the monitoring image provided from the power monitoring system according to an embodiment, so that an intuitive interface may be provided to a user. The arrow 123, which denotes the power supplying direction, may be plural. The plurality of arrows may be provided to each power distribution line so that a user may easily make determination.

Meanwhile, the battery information 130 showing the battery unit 110 may be provided at the left low end of the monitoring image.

When the battery unit may include a plurality of batteries, the battery information 130 may include the battery power information 131 including charging information about each battery. The battery power information 131 may include the active and reactive power values and the charged state provided to the power system corresponding to each battery.

Further the battery information 130 may further include information about outputs or available capabilities of each battery. As shown in the left bottom of FIG. 4, the available capability of battery 1 (BESS 1) is 500kWh and the output thereof is 2MW. The monitoring image may include a transformation state 134 of the transformer connected to the battery unit 110.

Meanwhile, as shown in FIG. 4, the monitoring image may include the power system information as a GUI. The connection relationship and state between each line and elements of the power system may be intuitively shown. The connection state of the power system may be shown by using breaker equipment 133. A state that the breaker equipment 133 is filled with a color may signify a state of transferring the electric power, that is, a close state.

Further, the monitoring image may further include compensator information 140 about the active and reactive power compensated by the compensator.

A load 150, to which the electric power is finally provided, may be denoted in the monitoring image, so that information 160 about a finally output power of an output line may be displayed. The power information 160 of the output line may include at least one of active power information 161, reactive power information 162 and voltage information 163.

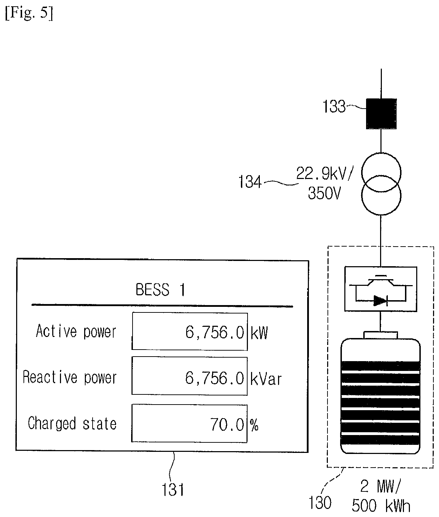

FIG. 5 is a view showing a shape of the battery unit in the monitoring image of the power monitoring system shown in FIG. 4.

As shown in FIG. 5, according to the embodiment, the shape of the battery unit 110 in the monitoring image of the power monitoring system may be differently displayed according to the charged state thereof. For example, as shown in FIG. 5, when the battery unit 110 is charged by 70.0%, the charge rate of the battery may be displayed with seven bars. Further, a shape or color of the battery unit may be changed according to the charge state and electric power information of the battery unit 110. Thus, a user may determine the state of the battery unit based on a numerical value, and in addition, may intuitively determine the state of the battery unit based on the color or shape.

According to the power monitoring system and the method of display power system information of the embodiment, a user can intuitively grasp a situation of the power system using new renewal energy. Specifically, power system information is displayed by using a user-friendly GUI (Graphical User Interface), so that a monitoring image interface through which a user easily knows the power system information can be provided. Therefore, the monitoring image which improves the use convenience of a user can be provided.

The method of displaying power system information according to the embodiment is realized in the form of a program executed in a computer and stored in a computer-readable medium. The computer-readable recording medium includes a ROM, a RAM, a CD-ROM, a magnetic tape, a floppy disk, and an optical data storage device. Further, the computer-readable recording medium may be implemented in the form of a carrier wave (for example, transmission through Internet)

The computer-readable recording medium may be distributed in computer systems connected with each other through a network and a code which is readable by a computer in a distribution scheme may be stored and executed in the computer-readable recording medium. A functional program, a code and code segments for implementing the method may be easily deduced by programmers skilled in the related art.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A method of displaying information about a power system (400), the method comprising:
receiving new renewal energy power information from a new renewal energy unit (200);
receiving battery power information and battery connection state information from a battery unit (300) comprising a plurality of batteries;
generating a GUI based monitoring image based on the new renewal energy power information, the battery power information and the battery connection state information;
displaying the monitoring image; and
receiving power system information from a power management unit,
wherein the battery power information comprises battery charging information about a battery charging state converted into a percentage value and at least one of active and reactive power values and a charge state provided from the battery unit, and
wherein the battery connection state information comprises information about a connection state and a disconnection state between the batteries.

2. The method of claim 1, wherein the generating of the monitoring image comprises:
generating the monitoring image based on the new renewal energy power information, the battery power information or the battery connection state information and the power system information.

3. The method of claim 1, wherein the new renewal energy power information includes an active or reactive power value provided from the new renewal energy unit (200).

4. The method of claim 2, wherein the power system information includes information about a connection state of the power system (400).

5. The method of claim 1, wherein the generating of the monitoring image comprises:
changing a shape or color of the battery unit (300) included in the monitoring image according to the battery power information.

6. A power monitoring system (400) comprising:
a new renewal energy unit (200) for receiving a power from a new renewal energy source to provide the power to a power system (400);
a battery unit (300) connected to the power system to be charged with the power provided from the new renewal energy unit or to provide the power to a load and comprises a plurality of batteries;
a power management unit (100) connected to the power system (400) to manage the new renewal energy unit and the battery unit; and
a client unit (110) connected to the power management unit (100) for displaying the monitoring image data,
wherein the power management unit (100) receives new renewal energy power information from the new renewal energy unit, receives battery power information and a battery connection state information from the battery unit in order to generate a GUI based monitoring image data based on the new renewal energy power information, the battery power information and the battery connection state information,
wherein the battery power information includes at least one of battery charging information about a battery charging state converted into a percentage value, and at least one of active and reactive power values provided from the battery unit (300) to the power system (400) and a charge state of each battery, **characterized in** comprising that
the battery connection state information comprises information about a connection state and a disconnection state between the batteries.

7. The power monitoring system of claim 6, wherein the power management unit (100) generates the monitoring image data based on power system information including information about a connection state of the power system and the new renewal energy power information, the battery power information or the battery connection state information.

8. The power monitoring system of claim 6, wherein the new renewal energy information includes active or reactive power value provided from the new renewal energy unit to the power system.

9. The power monitoring system of claim 6, wherein a shape or color of the battery unit (300) included in the monitoring image data is changed according to the battery power information.

## Patentansprüche

1. Verfahren zum Anzeigen von Informationen über ein Leistungssystem (400), wobei das Verfahren Folgendes umfasst:
Empfangen von Leistungsinformationen neuer erneuerbarer Energien von einer neuen erneuerbaren Energieeinheit (200);
Empfangen von Batterieleistungsinformationen und Batterieanschluss-Zustandsinformationen von einer Batterieeinheit (300), die eine Vielzahl von Batterien umfasst;
Erzeugen einer GUI-basierten Überwachung
Bild basierend auf den Leistungsinformationen neuer erneuerbarer Energien, den Batterieleistungsinformationen und den Batterieanschluss-Zustandsinformationen;
Anzeigen des Überwachungsbildes; und
Empfangen von Leistungsinformationen von einer Leistungsverwaltungseinheit,
wobei die Batterieleistungsinformation die Batterieladeinformationen über einen in einen Prozentwert umgerechneten Batterieladezustand und mindestens einen von Wirkleistungs- und Blindleistungswerten und einen von der Batterieeinheit bereitgestellten Ladezustand umfasst und
wobei die Batterieanschluss-Zustandsinformationen Informationen über einen Verbindungszustand und einen Trennzustand zwischen den Batterien umfassen.

2. Verfahren nach Anspruch 1, wobei das Erzeugen des Überwachungsbilds Folgendes umfasst:
Erzeugen des Überwachungsbildes basierend auf den Leistungsinformationen der neuen erneuerbaren Energien, den Batterieleistungsinformationen oder den Batterieanschluss-Zustandsinformationen und die Leistungssysteminformationen.

3. Verfahren nach Anspruch 1, wobei die Leistungsinformationen der neuen erneuerbaren Energien einen Wirkleistungs- oder Blindleistungswert beinhaltet, der von der neuen erneuerbaren Energieeinheit (200) bereitgestellt wird.

4. Verfahren nach Anspruch 2, wobei die Leistungssysteminformationen Informationen über einen Verbindungszustand des Leistungssystems (400) beinhalten.

5. Verfahren nach Anspruch 1, wobei das Erzeugen des Überwachungsbildes umfasst:
Ändern einer Form oder Farbe der Batterieeinheit (300), die im Überwachungsbild enthalten ist, gemäß den Batterieleistungsinformationen.

6. Leistungsüberwachungssystem (400), Folgendes umfassend:
eine neue erneuerbare Energieeinheit (200) zum Empfangen einer Leistung von einer neuen erneuerbaren Energiequelle, um die Leistung einem Leistungssystem (400) bereitzustellen;
eine Batterieeinheit (300), die mit dem Leistungssystem verbunden ist, um mit der von der neuen erneuerbaren Energieeinheit bereitgestellten Leistung geladen zu werden oder die Leistung für eine Last bereitzustellen und eine Vielzahl von Batterien umfasst;
eine Leistungsverwaltungseinheit (100), die mit dem Leistungssystem (400) verbunden ist, um die neue erneuerbare Energieeinheit und die Batterieeinheit zu verwalten; und
eine Kundeneinheit (110), die mit der Leistungsverwaltungseinheit (100) zur Anzeige der Überwachungsbilddaten verbunden ist,
wobei die Leistungsverwaltungseinheit (100) Leistungsinformationen neuer erneuerbarer Energien von der neuen erneuerbaren Energieeinheit empfängt, Batterieleistungsinformationen und eine Batterieanschluss-Zustandsinformation von der Batterieeinheit empfängt, um eine GUI-basierte Bilddatenüberwachung basierend auf den Leistungsinformationen der neuen erneuerbaren Energien, den Batterieleistungsinformationen und der Batterieanschluss-Zustandsinformation zu erzeugen,
wobei die Batterieleistungsinformation mindestens eine von Batterieladeinformationen über einen in einen Prozentwert konvertierten Batterieladezustand und mindestens einen von Wirkleistungs- und Blindleistungswerten, die von der Batterieeinheit (300) an das Leistungssystem (400) bereitgestellt werden, und einen Ladezustand jeder Batterie beinhaltet, **dadurch gekennzeichnet, dass** die Batterieanschluss-Zustandsinformationen Informationen über einen Verbindungszustand und einen Trennzustand zwischen den Batterien umfassen.

7. Leistungsüberwachungssystem nach Anspruch 6, wobei die Leistungsverwaltungseinheit (100) die Überwachungsbilddaten basierend auf Leistungssysteminformationen erzeugt, einschließlich Informationen über eine Verbindungzustand des Leistungssystems und den Leistungsinformationen der neuen erneuerbaren Energie, der Batterieleistungsinformationen oder der Batterieanschluss-Zustandsinformationen.

8. Leistungsüberwachungssystem nach Anspruch 6, wobei die Informationen der neuen erneuerbaren Energie Wirkleistungs- oder Blindleistungswerte, die von der neuen erneuerbaren Energieeinheit an das Leistungssystem bereitgestellt werden, beinhalten.

9. Leistungsüberwachungssystem nach Anspruch 6, wobei eine Form oder Farbe der Batterieeinheit (300), die in den Überwachungsbilddaten enthalten sind, gemäß den Batterieleistungsinformationen geändert wird.

## Revendications

1. Procédé d'affichage d'informations concernant un système d'alimentation (400), le procédé comprenant :
la réception d'informations d'alimentation de nouvelle énergie renouvelable depuis une unité de nouvelle énergie renouvelable (200) ;
la réception d'informations de puissance de batterie et d'informations d'état de connexion de batterie depuis une unité de batterie (300) comprenant une pluralité de batteries ;
la génération d'une image de surveillance basée sur une interface graphique utilisateur sur la base des informations d'alimentation de nouvelle énergie renouvelable, des informations de puissance de batterie et des informations d'état de connexion de batterie ;
l'affichage de l'image de surveillance ; et
la réception d'informations de système d'alimentation depuis une unité de gestion d'alimentation,
dans lequel les informations de puissance de batterie comprennent des informations de charge de batterie concernant l'état de charge d'une batterie converti en un pourcentage et au moins l'une des valeurs de puissance active et réactive et un état de charge fourni depuis l'unité de batterie, et
dans lequel les informations d'état de connexion de batterie comprennent des informations concernant un état de connexion et un état de déconnexion entre les batteries.

2. Procédé selon la revendication 1, dans lequel la génération de l'image de surveillance comprend :
la génération de l'image de surveillance sur la base des informations d'alimentation de nouvelle énergie renouvelable, des informations de puissance de batterie ou des informations d'état de connexion de batterie et des informations de système d'alimentation.

3. Procédé selon la revendication 1, dans lequel les informations d'alimentation de nouvelle énergie renouvelable comprennent une valeur de puissance active ou réactive fournie depuis l'unité de nouvelle énergie renouvelable (200).

4. Procédé selon la revendication 2, dans lequel les informations de système d'alimentation comprennent des informations concernant un état de connexion du système d'alimentation (400).

5. Procédé selon la revendication 1, dans lequel la génération de l'image de surveillance comprend :
la modification d'une forme ou d'une couleur de l'unité de batterie (300) comprise dans l'image de surveillance selon les informations de puissance de batterie.

6. Système de surveillance d'alimentation (400) comprenant :
une unité de nouvelle énergie renouvelable (200) destinée à recevoir une alimentation depuis une source de nouvelle énergie renouvelable pour alimenter un système d'alimentation (400) ;
une unité de batterie (300) connectée au système d'alimentation pour être chargée avec l'alimentation fournie par l'unité de nouvelle énergie renouvelable ou pour alimenter une charge et comprenant une pluralité de batteries ;
une unité de gestion d'alimentation (100) connectée au système d'alimentation (400) pour gérer l'unité de nouvelle énergie renouvelable et l'unité de batterie ; et
une unité cliente (110) connectée à l'unité de gestion d'alimentation (100) destinée à afficher les données d'image de surveillance,
dans lequel l'unité de gestion d'alimentation (100) reçoit des informations d'alimentation de nouvelle énergie renouvelable depuis l'unité de nouvelle énergie renouvelable, reçoit des informations de puissance de batterie et des informations d'état de connexion de batterie depuis l'unité de batterie afin de générer les données d'une image de surveillance basée sur une interface graphique utilisateur sur la base des informations d'alimentation de nouvelle énergie renouvelable, des informations de puissance de batterie et des informations d'état de connexion de batterie,
dans lequel les informations d'alimentation de batterie comprennent au moins les unes des informations de charge de batterie concernant l'état de charge d'une batterie converti en un pourcentage, et au moins l'une des valeurs de puissance active et réactive fournies depuis l'unité de batterie (300) vers le système d'alimentation (400) et un état de charge de chaque batterie, **caractérisé en ce qu'**il comprend le fait que les informations d'état de connexion de batterie comprennent des informations concernant un état de connexion et un état de déconnexion entre les batteries.

7. Système de surveillance d'alimentation selon la revendication 6, dans lequel l'unité de gestion d'alimentation (100) génère les données d'image de surveillance sur la base d'informations de système d'alimentation comprenant des informations concernant un état de connexion du système d'alimentation et les informations d'alimentation de nouvelle énergie renouvelable, les informations de puissance de batterie ou les informations d'état de connexion de batterie.

8. Système de surveillance d'alimentation selon la revendication 6, dans lequel les informations de nouvelle énergie renouvelable comprennent une valeur de puissance active ou réactive fournie depuis l'unité de nouvelle énergie renouvelable vers le système d'alimentation.

9. Système de surveillance d'alimentation selon la revendication 6, dans lequel une forme ou une couleur de l'unité de batterie (300) comprise dans les données d'image de surveillance est modifiée selon les informations de puissance de batterie.
